# EUROPEAN PATENT APPLICATION

(11) **EP 4 741 856 A1**
(43) Date of publication of application: **13.05.2026**
(21) Application number: 25209417.2
(22) Date of filing: 17.10.2025
(51) Int. Cl.: G01R 31/396, H01M 10/42, H02J 7/00

(54) **MULTIPLEXER CIRCUIT FOR A BATTERY MANAGEMENT SYSTEM, AND CORRESPONDING BATTERY MANAGEMENT SYSTEM**

(30) Priority: 07.11.2024 IT 202400025068
(71) Applicant: STMicroelectronics International N.V., 1228 Plan-les-Ouates, Geneva (CH)
(72) Inventor: CURINA, Carlo, I-10040 Lombardore (Torino) (IT); BENDOTTI, Valerio, I-20007 Cornaredo (Milano) (IT); MARZIOLI, Alice, I-20881 Bernareggio (Monza Brianza) (IT)
(74) Representative: Buzzi, Notaro & Antonielli d'Oulx S.p.A.

(57) **Abstract**

A MUX (72) for a battery management system (10') includes a first input terminal for coupling to a first pin (Cᵢ) of a battery stack (B), a second input terminal for coupling to a second pin (Cᵢ₋₁) of the battery stack (B), and a third input terminal for coupling to a third pin (Cᵢ₋₂) of the battery stack (B). A first switch (SWᵢ) has a respective first terminal (100ᵢ) coupled to the first input terminal of the MUX, a second switch (SWᵢ₋₁) has a respective first terminal (100ᵢ₋₁) coupled to the second input terminal of the MUX, and a third switch (SWᵢ₋₂) has a respective first terminal (100ᵢ₋₂) coupled to the third input terminal of the MUX. An AFE and selection circuit (724) includes a first input terminal coupled to a second terminal (102ᵢ) of the first switch (SWᵢ), a second input terminal coupled to a second terminal (102ᵢ₋₁) of the second switch (SWᵢ₋₁), a third input terminal coupled to a second terminal (102ᵢ₋₂) of the third switch (SWᵢ₋₂), a first output terminal for coupling to a positive input of a first level shifter circuit (16ᵢ), a second output terminal for coupling to a negative input of the first level shifter circuit (16ᵢ), a third output terminal for coupling to a positive input of a second level shifter circuit (16ᵢ₋₁), and a fourth output terminal for coupling to a negative input of the second level shifter circuit (16ᵢ₋₁). Each of the first, second, third and fourth output terminals of the AFE and selection circuit (724) is selectively couplable to any of the first, second and third input terminals of the AFE and selection circuit (724).

## Description

### Technical field

The description relates to multiplexer circuits (MUX) that can be used in battery management systems (BMS), in particular for coupling the pins of a stack of battery cells to the input terminals of a set of analog-to-digital converters (ADC) of the BMS.

### Technological background

A battery management system is an electronic device or system configured to monitor and/or control a rechargeable battery. For instance, a BMS can be configured to control the battery so that it does not operate outside its safe operating area (SOA), and/or to monitor the state of the battery by running some diagnosis procedures. Batteries couplable to a BMS can include, for instance, high-voltage (e.g., 400 V or 800 V) battery packs for battery electric vehicles (BEV) or hybrid electric vehicles (HEV and PHEV), mild-voltage (e.g., 48 V) battery packs for mild-hybrid electric vehicles (MHEV), batteries for backup energy storage systems and uninterruptible power supplies (UPS), and the like.

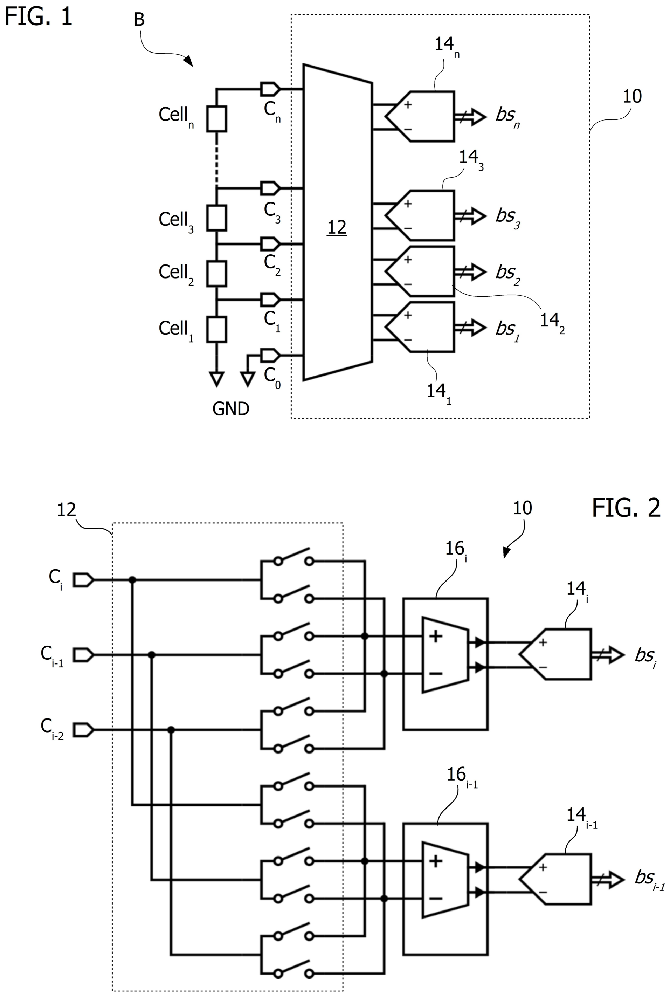

A function of a BMS device is that of measuring the voltage of each battery cell inside the stack of cells (i.e., a plurality of cells connected in series) of a battery or battery pack, in order to be able to carry out some internal functions such as charge balancing, diagnosis, temperature sensing, and others. Usually, due to timing requirements, each of the n cells of the stack has to be selectively connectable to a dedicated ADC circuit. In this respect, reference may be made to Figure 1, which is a circuit block diagram exemplary of a possible arrangement of a battery B coupled to a BMS 10. The battery B includes a stack of n battery cells coupled in series, from a "lowest" (or first) cell Cell₁ to a "highest" (or n^{th}) cell Cellₙ. The first cell Cell₁ has its anode terminal coupled to ground GND and its cathode terminal coupled to the anode terminal of the second cell Cell₂, each intermediate cell (from Cell₂ to Cellₙ₋₁) has its anode terminal coupled to the cathode terminal of a previous cell and its cathode terminal coupled to the anode terminal of a next cell, and the last cell Cellₙ has its anode terminal coupled to the cathode terminal of the previous cell Cellₙ₋₁ and its cathode terminal coupled to a topmost pin of the battery stack, which provides the maximum output voltage of the battery stack. The battery stack has *n+l1* pins, including a pin C₀ coupled to ground, and pins C₁ to Cₙ each coupled to the cathode terminal of the respective cell (i.e., Cell₁ to Cellₙ). The BMS 10 includes an analog multiplexer circuit 12 having n+1 input terminals, each coupled to a respective one of the pins C₀ to Cₙ of the battery stack, and n pairs of output terminals, each pair being coupled to the input port of a respective ADC circuit 14. The ADC circuits 14₁ to 14ₙ produce respective digital output signals (e.g., multi-bit signals) *bs₁* to *bsₙ.* Due to the typical voltage ratings of the battery B, the MUX 12 may be designed to withstand an absolute maximum voltage of about 100 V pin-to-pin and pin-to-ground.

In order to better understand the connections that can be implemented by the MUX 12, reference can be made to Figure 2, which is a circuit block diagram showing in detail the architecture of the MUX 12 that is implemented for connecting the pins of two consecutive cells, a generic odd-numbered cell Cellᵢ₋₁ and a generic even-numbered cell Cellᵢ, to the respective ADCs 14ᵢ₋₁ and 14ᵢ. It will be understood that the architecture of Figure 2 may be replicated, in the MUX 12, for each pair of consecutive battery cells (each pair comprising an odd-numbered cell and an even-numbered cell, e.g., Cell₁ and Cell₂, Cell₁ and Cell₄, up to Cellₙ₋₁ and Cellₙ). By looking at Figure 2, it will thus be noted that each input terminal (i.e., both the positive input terminal and the negative input terminal) of each ADC should be selectively couplable to both the cathode and the anode of the respective battery cell via dedicated switches, so that each ADC in generic position j can read the voltage of the corresponding battery cell in position j while also allowing to perform a chop function; to this aim, eight switches have to be implemented. In addition, the possibility to implement a swap function is usually demanded for safety, allowing each odd-numbered ADC (e.g., 14ᵢ₋₁) to read the voltage of the corresponding even-numbered cell in the same pair (e.g., Cellᵢ) and allowing each even-numbered ADC (e.g., 14ᵢ) to read the voltage of the corresponding odd-numbered cell in the same pair (e.g., Cellᵢ₋₁): this implies that each input terminal (i.e., both the positive input terminal and the negative input terminal) of each odd-numbered ADC should also be selectively couplable via dedicated switches to the cathode of the corresponding even-numbered battery cell in the same pair of cells, and that each input terminal (i.e., both the positive input terminal and the negative input terminal) of each even-numbered ADC should also be selectively couplable via dedicated switches to the anode of the corresponding odd-numbered battery cell in the same pair of cells; to this aim, additional four switches have to be implemented. As a result, the MUX 12 implements with dedicated switches, for each pair of ADCs (14ᵢ and 14ᵢ₋₁), all possible selective connections to the three pins of the corresponding pair of cells (Cᵢ, Cᵢ₋₁ and Cᵢ₋₂), for a total count of twelve high-voltage switches that are designed to withstand a high absolute maximum voltage (e.g., 100 V) and so are realized with high-voltage components that are expensive in terms of silicon area. In addition, a respective level shifter circuit 16 is usually arranged between the output terminals of the switches of the MUX 12 and the input port of the corresponding ADC circuit to adapt the voltage level for the conversion.

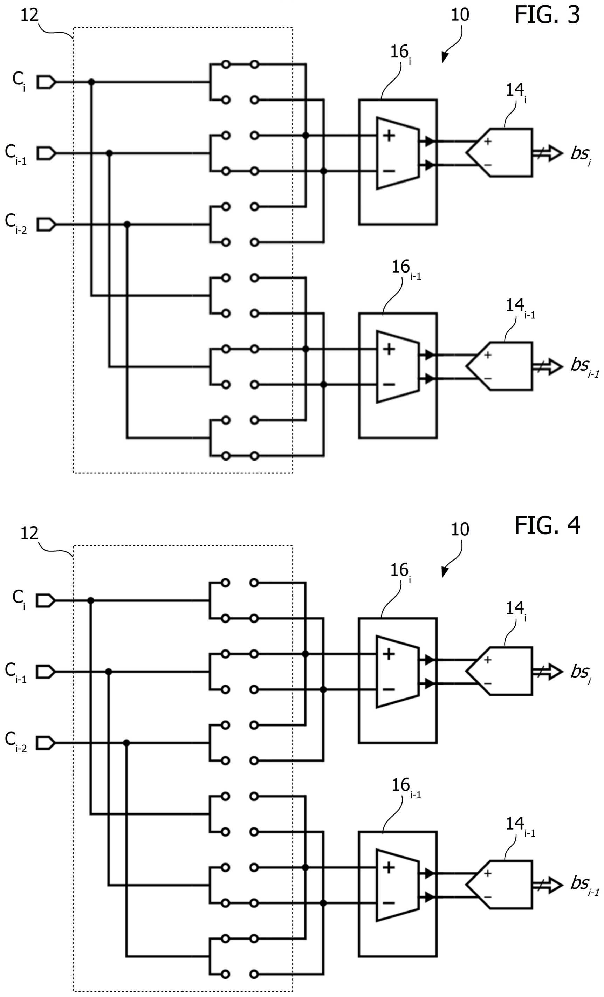

Figure 3 is a circuit block diagram exemplary of the possible arrangement of the switches of the MUX 12 (still with reference to a single pair of battery cells and corresponding ADCs, which can be replicated for each pair in the battery stack B) when there is no swapping (swap = '0') nor chopping (chop = '0'). The positive input of the even-numbered ADC 14ᵢ is coupled to the cathode of the corresponding even-numbered cell Cellᵢ at pin Cᵢ, the negative input of the even-numbered ADC 14ᵢ is coupled to the anode of the corresponding even-numbered cell Cellᵢ at pin Cᵢ₋₁, the positive input of the odd-numbered ADC 14ᵢ₋₁ is coupled to the cathode of the corresponding odd-numbered cell Cellᵢ₋₁ at pin Cᵢ₋₁, and the negative input of the odd-numbered ADC 14ᵢ₋₁ is coupled to the anode of the corresponding odd-numbered cell Cellᵢ₋₁ at pin Cᵢ₋₂.

Figure 4 is a circuit block diagram exemplary of the possible arrangement of the switches of the MUX 12 (still with reference to a single pair of battery cells and corresponding ADCs) when there is no swapping (swap = '0') but there is chopping (chop = '1'). The positive input of the even-numbered ADC 14ᵢ is coupled to the anode of the corresponding even-numbered cell Cellᵢ at pin Cᵢ₋₁, the negative input of the even-numbered ADC 14ᵢ is coupled to the cathode of the corresponding even-numbered cell Cellᵢ at pin Cᵢ, the positive input of the odd-numbered ADC 14ᵢ₋₁ is coupled to the anode of the corresponding odd-numbered cell Cellᵢ₋₁ at pin Cᵢ₋₂, and the negative input of the odd-numbered ADC 14ᵢ₋₁ is coupled to the cathode of the corresponding odd-numbered cell Cellᵢ₋₁ at pin Cᵢ₋₁. Thus, chopping involves an inversion of the polarity of the voltage measurement.

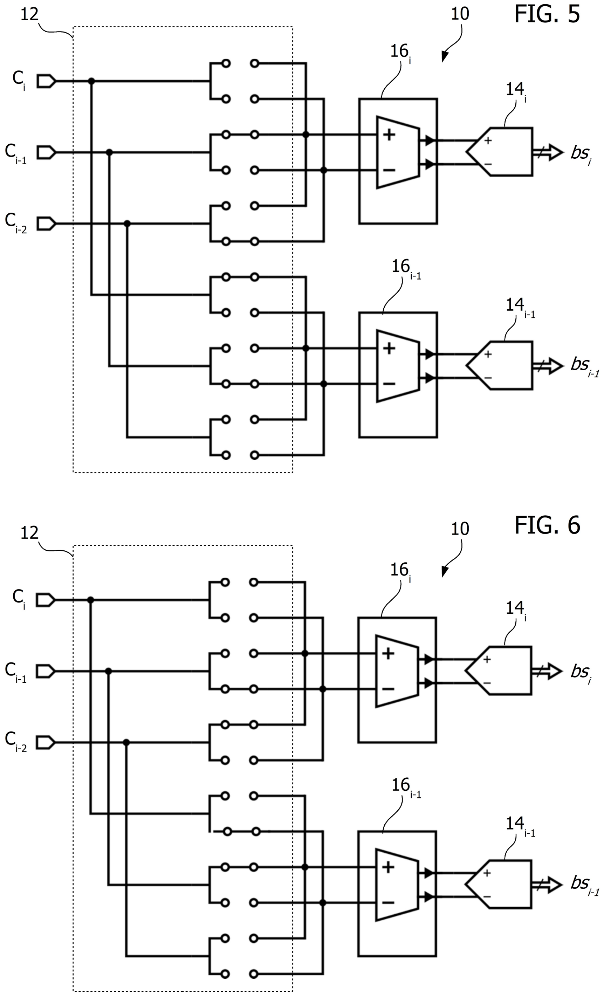

Figure 5 is a circuit block diagram exemplary of the possible arrangement of the switches of the MUX 12 (still with reference to a single pair of battery cells and corresponding ADCs) when there is swapping (swap = '1') and no chopping (chop = '0'). The positive input of the even-numbered ADC 14ᵢ is coupled to the cathode of the corresponding odd-numbered cell Cellᵢ₋₁ at pin Cᵢ₋₁, the negative input of the even-numbered ADC 14ᵢ is coupled to the anode of the corresponding odd-numbered cell Cellᵢ₋₁ at pin Cᵢ₋₂, the positive input of the odd-numbered ADC 14ᵢ₋₁ is coupled to the cathode of the corresponding even-numbered cell Cellᵢ at pin Cᵢ, and the negative input of the odd-numbered ADC 14ᵢ₋₁ is coupled to the anode of the corresponding even-numbered cell Cellᵢ at pin Cᵢ₋₁.

Figure 6 is a circuit block diagram exemplary of the possible arrangement of the switches of the MUX 12 (still with reference to a single pair of battery cells and corresponding ADCs) when there is both swapping (swap = '1') and chopping (chop = '1'). The positive input of the even-numbered ADC 14ᵢ is coupled to the anode of the corresponding odd-numbered cell Cellᵢ₋₁ at pin Cᵢ₋₂, the negative input of the even-numbered ADC 14ᵢ is coupled to the cathode of the corresponding odd-numbered cell Cellᵢ₋₁ at pin Cᵢ₋₁, the positive input of the odd-numbered ADC 14ᵢ₋₁ is coupled to the anode of the corresponding even-numbered cell Cellᵢ at pin Cᵢ₋₁, and the negative input of the odd-numbered ADC 14ᵢ₋₁ is coupled to the cathode of the corresponding even-numbered cell Cellᵢ at pin Cᵢ.

Multiplexers for use in battery management systems are also known in the art. For instance, U.S. Patent Application publication No. US 2021/0391731 A1 discloses an electrically-powered aircraft including a BMS. The BMS includes a battery pack controller which monitors and controls operation of a battery pack string. The battery pack string includes a set of battery packs. The controller includes a microcontroller unit (MCU) which can be coupled to each battery pack via SPI interfaces and I/O expander ICs. Each battery pack includes a battery supervisory circuit that, amongst other operations, also conditions and digitizes voltages and temperatures of the individual battery cells. The voltage measurements for each battery cell are provided using a differential amplifier, which functions as a voltage sensor, on the high voltage side. The measured parameters from the differential amplifiers are inputted to one or more multiplexers. The one or more multiplexers may include a 2:1 multiplexer and a 4:1 multiplexer. The output from the 2:1 multiplexer and the 4:1 multiplexer are inputted to an ADC.

U.S. Patent Application publication No. US 2022/0219544 A1 discloses a method to control a battery management system. A first voltage drop is sensed between a first terminal of a first battery cell and a second terminal of the first battery cell and a second voltage drop is sensed between a first terminal of a second battery cell and a second terminal of the second battery cell. A faulty condition is detected in the first battery cell or the second battery cell based on the first voltage drop or the second voltage drop. The first voltage drop is swapped for a first swapped voltage drop between a common terminal and the second terminal of the second battery cell.

U.S. Patent publication No. US 9340122 B2 discloses a BMS having a conventional architecture with a single-stage multiplexer arranged upstream of the amplifier and ADC.

U.S. Patent Application publication No. US 2024/0080035 A1 discloses a sigma-delta ADC for a BMS. A high-voltage selection switch is coupled in series to each pin of the battery cell stack, and high-voltage chopping switches are connected between the high-voltage selection switches and the input terminals of the amplifier.

Chinese Patent Application publication No. CN 116961636 A discloses a high-voltage switch circuit and a battery monitoring high-voltage multiplexer using the circuit. A unit capable of preventing reverse conduction of a switch is designed in the high-voltage switch, a non-sampling channel can be strictly closed, the strictly closed channel does not influence a normal sampling channel, and the sampling channel is not influenced by the non-sampling channel.

The publication Chih-Lin Chen, Yi Hu, Wayne Luo, Chua-Chin Wang and Chun-Ying Juan, "A high voltage analog multiplexer with digital calibration for battery management systems", 2012 IEEE International Conference on IC Design & Technology, Austin, TX, 2012, pp. 1-4, doi: 10.1109/ICICDT.2012.6232881 discloses a high-voltage multiplexer for a BMS, which includes one high-voltage switch for each pin of the battery stack, and a conventional architecture with a large 8:1 multiplexer.

In the solutions discussed above, both protection and chop + swap functions are carried out by the same high-voltage switches, which are high in number. Therefore, there is a need in the art to provide improved multiplexer circuits for use in battery management systems, which have a simpler design and use less high-voltage switches, and thus occupy less silicon area.

### Object and summary

An object of one or more embodiments is to contribute in providing such improved multiplexer circuits, and corresponding battery management systems.

According to one or more embodiments, such an object can be achieved by a multiplexer circuit having the features set forth in the claims that follow.

One or more embodiments may relate to a corresponding battery management system.

The claims are an integral part of the technical teaching provided herein in respect of the embodiments.

According to an aspect of the present description, a multiplexer circuit (MUX) includes a first input terminal configured for coupling to a first pin of a battery stack, a second input terminal configured for coupling to a second pin of the battery stack, and a third input terminal configured for coupling to a third pin of the battery stack. The MUX includes a first switch having a respective first terminal coupled to the first input terminal of the MUX, a second switch having a respective first terminal coupled to the second input terminal of the MUX, and a third switch having a respective first terminal coupled to the third input terminal of the MUX. The MUX includes an analog front end (AFE) and selection circuit that includes a first input terminal coupled to a second terminal of the first switch, a second input terminal coupled to a second terminal of the second switch, a third input terminal coupled to a second terminal of the third switch, a first output terminal configured for coupling to a positive input of a first level shifter circuit, a second output terminal configured for coupling to a negative input of the first level shifter circuit, a third output terminal configured for coupling to a positive input of a second level shifter circuit, and a fourth output terminal configured for coupling to a negative input of the second level shifter circuit. Each of the first, second, third and fourth output terminals of the AFE and selection circuit is selectively couplable to any of the first, second and third input terminals of the AFE and selection circuit.

One or more embodiments may thus provide a multiplexer circuit for use in a BMS, with a low number of high-voltage switches and a low silicon area footprint.

According to another aspect of the present description, a battery management system includes a multiplexer circuit according to one or more embodiments, a first (e.g., odd-numbered) level shifter circuit, a second (e.g., even-numbered) level shifter circuit, a first (e.g., odd-numbered) ADC circuit, and a second (e.g., even-numbered) ADC circuit. The first level shifter circuit has a positive input coupled to the first output terminal of the AFE and selection circuit, a negative input coupled to the second output terminal of the AFE and selection circuit, and an output port. The second level shifter circuit has a positive input coupled to the third output terminal of the AFE and selection circuit, a negative input coupled to the fourth output terminal of the AFE and selection circuit, and an output port. The first ADC circuit has an input port coupled to the output port of the first level shifter circuit. The second ADC circuit has an input port coupled to the output port of the second level shifter circuit.

### Brief description of the figures

One or more embodiments will now be described, by way of example only, with reference to the annexed figures, wherein:
- Figure 1, previously presented, is a circuit block diagram exemplary of a battery coupled to a BMS that includes a MUX;
- Figure 2, previously presented, is a circuit block diagram exemplary of a conventional architecture of a portion of a MUX that connects the pins of two consecutive battery cells to the respective ADCs of the BMS;
- Figure 3, previously presented, is a circuit block diagram exemplary of the possible arrangement of the switches of the MUX of Figure 2 when there is no swapping nor chopping of the voltage sensing;
- Figure 4, previously presented, is a circuit block diagram exemplary of the possible arrangement of the switches of the MUX of Figure 2 when there is no swapping but there is chopping of the voltage sensing;
- Figure 5, previously presented, is a circuit block diagram exemplary of the possible arrangement of the switches of the MUX of Figure 2 when there is swapping and no chopping of the voltage sensing;
- Figure 6, previously presented, is a circuit block diagram exemplary of the possible arrangement of the switches of the MUX of Figure 2 when there is both swapping and chopping of the voltage sensing;
- Figure 7 is a circuit block diagram exemplary of a portion of a BMS according to one or more embodiments of the present description, in particular including a portion of an analog MUX, and corresponding level shifters and ADCs;
- Figure 8 is a circuit block diagram exemplary of a possible implementation of the analog MUX of the BMS of Figure 7;
- Figure 9 is a circuit block diagram exemplary of another possible implementation of the analog MUX of the BMS of Figure 7;
- Figure 10 is a circuit diagram exemplary of a possible transistor-level implementation of an analog-front-end and selector circuit of the analog MUX of Figure 9;
- Figure 11 is a circuit block diagram exemplary of the possible arrangement of the switches of the MUX of Figure 9 when there is no swapping nor chopping of the voltage sensing;
- Figure 12 is a circuit block diagram exemplary of the possible arrangement of the switches of the MUX of Figure 9 when there is no swapping but there is chopping of the voltage sensing;
- Figure 13 is a circuit block diagram exemplary of the possible arrangement of the switches of the MUX of Figure 9 when there is swapping and no chopping of the voltage sensing;
- Figure 14 is a circuit block diagram exemplary of the possible arrangement of the switches of the MUX of Figure 9 when there is both swapping and chopping of the voltage sensing; and
- Figure 15 is a circuit block diagram exemplary of a possible implementation of an analog MUX of another BMS, where the MUX can additionally receive a signal from a general-purpose input pin referenced to ground and from a reference voltage pin for the purpose of carrying out a built-in self-test.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

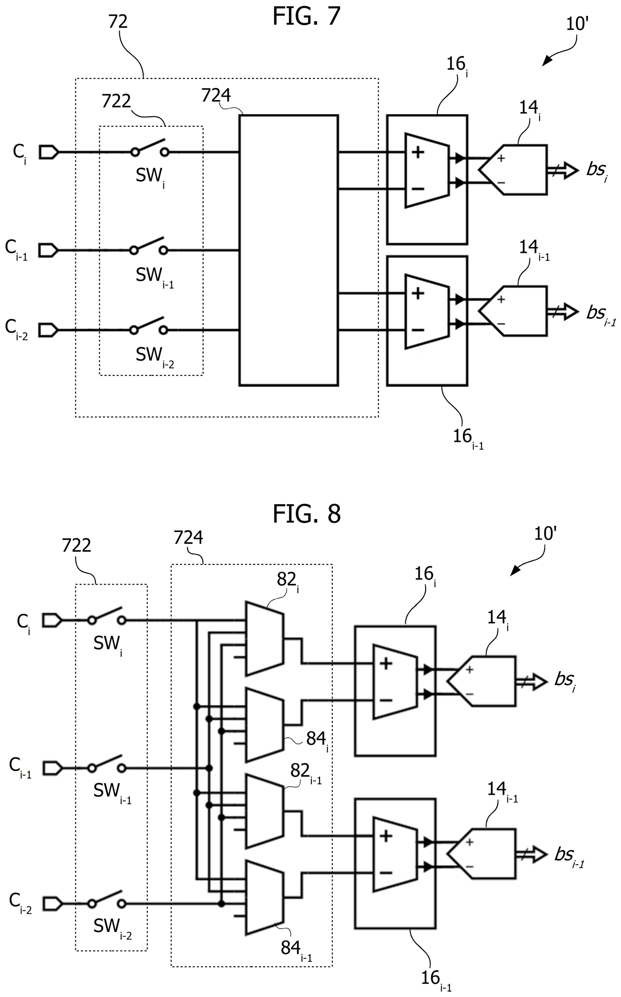

As anticipated, multiplexers having a simpler design and using less high-voltage switches compared to the prior art are desirable. Therefore, one or more embodiments relate to a multiplexer design as exemplified in the circuit block diagram of Figure 7, which shows (similarly to Figure 2, previously discussed) the architecture of a MUX 72 that is implemented for connecting the pins of two consecutive cells, a generic odd-numbered cell Cellᵢ₋₁ and a generic even-numbered cell Cellᵢ, to the respective ADCs 14ᵢ₋₁ and 14ᵢ of a BMS 10' (via respective level shifters 16ᵢ₋₁ and 16ᵢ). Just like described with reference to Figure 2, the architecture shown in Figure 7 may be replicated, in the MUX 72 of a BMS, for each pair of consecutive battery cells of the battery (each pair comprising an odd-numbered cell and an even-numbered cell, e.g., Cell₁ and Cell₂, Cell₃ and Cell₄, up to Cellₙ₋₁ and Cellₙ). As will be further described in the following, the architecture of Figure 7 also allows to connect each input terminal of each of the ADCs 14ᵢ₋₁ and 14ᵢ to any of the pins Cᵢ, Cᵢ₋₁ and Cᵢ₋₂ of the battery stack, but uses a lower number of high-voltage switches compared to the architecture of Figure 2 by splitting the MUX 72 in two sub-circuits, in particular a first circuit 722 that provides high-voltage protection and a second circuit 724 that allows to carry out the chop and swap functions, and also operates as an analog front end (AFE) for the subsequent electronics (i.e., level shifters 16 and ADCs 14).

The protection circuit 722 includes three input terminals and three output terminals. Each input terminal is connected to a respective one of pins Cᵢ, Cᵢ₋₁ and Cᵢ₋₂. A respective high-voltage switch is coupled in series between each input terminal and the corresponding output terminal (switches SWᵢ, SWᵢ₋₁ and SWᵢ₋₂), so that the output terminals of the protection circuit 722 can be protected from the high voltage coming from the battery pins Cᵢ, Cᵢ₋₁ and Cᵢ₋₂.

The AFE and selection circuit 724 (whose internal structure will be further described in the following) allows to implement the chop and swap functions (i.e., connect each of the input terminals of the ADCs 14, via the level shifters 16, to any of the pins Cᵢ, Cᵢ₋₁ and Cᵢ₋₂) and operates as an analog front end so that the downstream circuitry (level shifters and ADCs) can receive a maximum voltage corresponding to the low voltage level of the design.

A possible implementation of the AFE circuit 724 is exemplified in the circuit block diagram of Figure 8. In this example, each input terminal of the ADCs 14ᵢ₋₁ and 14ᵢ is coupled, via the corresponding level shifter circuit 16, to the output terminal of a respective 4:1 multiplexer. Thus, the positive input terminal of level shifter 16ᵢ is connected to the output of a 4:1 MUX 82ᵢ, the negative input terminal of level shifter 16ᵢ is connected to the output of a 4:1 MUX 84ᵢ, the positive input terminal of level shifter 16ᵢ₋₁ is connected to the output of a 4:1 MUX 82ᵢ₋₁, and the negative input terminal of level shifter 16ᵢ₋₁ is connected to the output of a 4:1 MUX 84ᵢ₋₁. The first input terminals of all MUXes 82 and 84 are connected to the output of the first switch SWᵢ, the second input terminals of all MUXes 82 and 84 are connected to the output of the second switch SWᵢ₋₁, and the third input terminals of all MUXes 82 and 84 are connected to the output of the third switch SWᵢ₋₂. The fourth input terminals of all MUXes 82 and 84 may not be used (e.g., indifferently left floating or connected to GND, insofar as the fourth input is not or never connected to the output of the MUX). By doing so, each of pins Cᵢ, Cᵢ₋₁ and Cᵢ₋₂ can be selectively connected to any of the input terminals of the level shifters 16ᵢ and 16ᵢ₋₁, and the AFE circuit 724 allows to carry out both the chop function and the swap function. While simple, the implementation of Figure 8 may still have some drawbacks, insofar as each of the MUXes 82 and 84 can have its input terminals coupled to both pins Cᵢ and Cᵢ₋₂. This results in that the maximum differential voltage that each MUX has to withstand corresponds to twice the cell voltage (e.g., if V_{cell} = 5.5 V, then the maximum input differential voltage is V_{diff_max} = 11 V), which fact in turn calls for the MUXes to be implemented using components with a 12 V voltage rating, which may be complex to be properly driven.

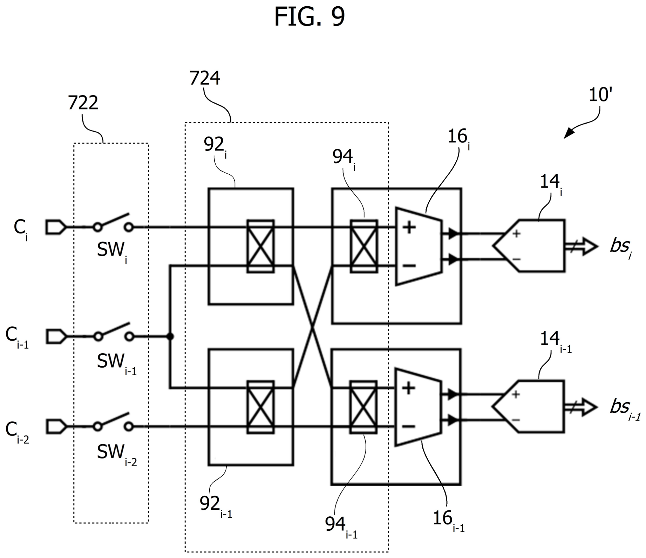

To further improve the architecture of the AFE circuit 724, one or more embodiments may rely on the possible implementation exemplified in the circuit block diagram of Figure 9. In this example, the AFE circuit 724 is split into two cascaded sections.

The first section of the AFE circuit 724 includes a first selector 92ᵢ and a second selector 92ᵢ₋₁, each having two input terminals and two output terminals. In particular, the first input terminal of selector 92ᵢ is connected to the output of the first high-voltage switch SWᵢ, the second input terminal of selector 92ᵢ is connected to the output of the second high-voltage switch SWᵢ₋₁, the first input terminal of selector 92ᵢ₋₁ is connected to the output of the second high-voltage switch SWᵢ₋₁, and the second input terminal of selector 92ᵢ₋₁ is connected to the output of the third high-voltage switch SWᵢ₋₂. Inside each selector 92, low-voltage switches are arranged so that any input terminal of the selector can be selectively coupled to any output terminal of the selector (e.g., each selector 92 may substantially include a pair of 2:1 MUXes and/or CMOS passgate circuits), and the selectors 92 also implement the analog front end functionality, as described in greater detail in the following. The selectors 92ᵢ and 92ᵢ₋₁ also allow to carry out the swap function of the cells Cellᵢ and Cellᵢ₋₁.

The second section of the AFE circuit 724 includes a first selector 94ᵢ and a second selector 94ᵢ₋₁, each having two input terminals and two output terminals. In particular, the first input terminal of selector 94ᵢ is connected to the first output terminal of the selector 92ᵢ, the second input terminal of selector 94ᵢ is connected to the first output terminal of selector 92ᵢ₋₁, the first input terminal of selector 94ᵢ₋₁ is connected to the second output terminal of the selector 92ᵢ, and the second input terminal of selector 94ᵢ₋₁ is connected to the second output terminal of selector 92ᵢ₋₁. Inside each selector 94, low-voltage switches are arranged so that any input terminal of the selector can be selectively coupled to any output terminal of the selector (e.g., each selector 94 may substantially include a pair of 2:1 MUXes and/or CMOS passgate circuits). The first output terminal of selector 94ᵢ is connected to the positive input terminal of the level shifter 16ᵢ, the second output terminal of selector 94ᵢ is connected to the negative input terminal of the level shifter 16ᵢ, the first output terminal of selector 94ᵢ₋₁ is connected to the positive input terminal of the level shifter 16ᵢ₋₁, and the second output terminal of selector 94ᵢ₋₁ is connected to the negative input terminal of the level shifter 16ᵢ₋₁. The selectors 94ᵢ and 94ᵢ₋₁ also allow to carry out the chop function of the cells Cellᵢ and Cellᵢ₋₁.

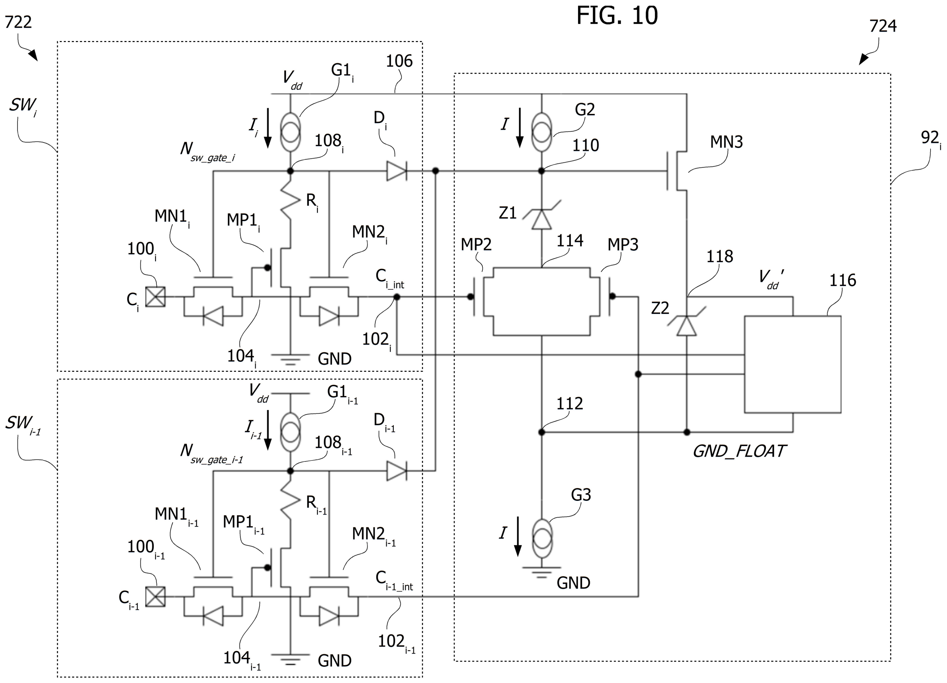

Figure 10 is a circuit diagram exemplary of a possible detailed implementation (e.g., transistor-level implementation) of the high-voltage switches SWᵢ and SWᵢ₋₁ as well as selector 92ᵢ as visible in Figure 9, which implements the AFE functionality and the swap functionality.

The switch SWᵢ has an input node 100ᵢ configured for coupling to the battery pin Cᵢ, and an output node 102ᵢ (also indicated as C_{i_int}, insofar as it passes internally the voltage of pin Cᵢ when switch SWᵢ is closed) configured for coupling to the first input terminal of selector 92ᵢ. Two n-channel MOS transistors MN1ᵢ and MN2ᵢ (having respective body diodes indicated in Figure 10) may be coupled with their conductive channels arranged in series between node 100ᵢ and node 102ᵢ, in particular with the drain terminal of transistor MN1ᵢ coupled to node 100ᵢ, the drain terminal of transistor MN2ᵢ coupled to node 102ᵢ, and the source terminals of transistors MN1ᵢ and MN2ᵢ coupled to each other at a node 104ᵢ. The switch SWᵢ may also include a current source G1ᵢ coupled between a power supply rail 106 (e.g., providing a power supply voltage *V_{dd}*) and a selection node 108ᵢ, the current source G1ᵢ being configured to source a current Iᵢ to node 108ᵢ. The power supply rail 106 may be common to the whole AFE circuit 724 or even to the whole MUX 72. A resistor Rᵢ and a p-channel MOS transistor MP1ᵢ may be arranged in series between node 108ᵢ and ground GND, in particular with a first terminal of resistor Rᵢ coupled to node 108ᵢ, a second terminal of resistor Rᵢ coupled to the source terminal of transistor MP1ᵢ, and the drain terminal of transistor MP1ᵢ coupled to ground GND. The gate terminals of transistors MN1ᵢ and MN2ᵢ are coupled to the selection node 108ᵢ, and the gate terminal of transistor MP1ᵢ is coupled to node 104ᵢ. Furthermore, the switch SWᵢ may include a diode Dᵢ having an anode terminal coupled to the selection node 108ᵢ and a cathode terminal coupled to a biasing node 110 external to the switch SWᵢ (e.g., with the biasing node 110 being common to the whole AFE circuit 724 or even to the whole MUX 72).

The switch SWᵢ₋₁ may have substantially the same internal structure of switch SWᵢ, in particular an input node 100ᵢ₋₁ configured for coupling to the battery pin Cᵢ₋₁, an output node 102ᵢ₋₁ (also indicated as C_{i-1_int}) configured for coupling to the second input terminal of selector 92ᵢ, two n-channel MOS transistors MNlᵢ₋₁ and MN2ᵢ₋₁ coupled with their conductive channels arranged in series between node 100ᵢ₋₁ and node 102ᵢ₋₁ (in particular with the drain terminal of transistor MN1ᵢ₋₁ coupled to node 100ᵢ₋₁, the drain terminal of transistor MN2ᵢ₋₁ coupled to node 102ᵢ₋₁, and the source terminals of transistors MNlᵢ₋₁ and MN2ᵢ₋₁ coupled to each other at a node 104ᵢ₋₁), a current source G1ᵢ₋₁ coupled between the power supply rail 106 and a selection node 108ᵢ₋₁ to source a current Iᵢ₋₁ to node 108ᵢ₋₁, a resistor Rᵢ₋₁ and a p-channel MOS transistor MP1ᵢ₋₁ arranged in series between node 108ᵢ₋₁ and ground GND (with the gate terminals of transistors MNlᵢ₋₁ and MN2ᵢ₋₁ coupled to the selection node 108ᵢ₋₁, and the gate terminal of transistor MP1ᵢ₋₁ coupled to node 104ᵢ₋₁), a diode Dᵢ₋₁ coupled between the selection node 108ᵢ₋₁ and the biasing node 110.

The AFE and selector circuit 92ᵢ has two input nodes configured for coupling to the nodes 102ᵢ and 102ᵢ₋₁ at the output of switches SWᵢ and SWᵢ₋₁. The AFE portion of circuit 92ᵢ may include a current source G2 coupled between the power supply rail 106 and the biasing node 110, the current source G2 being configured to source a current I to node 110. The AFE portion of circuit 92ᵢ may include a pair of p-channel MOS transistors MP2 and MP3 coupled with their conductive channels arranged in parallel to each other between a floating ground node 112 and a node 114, in particular with the drain terminals coupled to node 112 and the source terminals coupled to node 114. The gate terminal of transistor MP2 may be coupled to node 102ᵢ (at the output of switch SWᵢ) and the gate terminal of transistor MP3 may be coupled to node 102ᵢ₋₁ (at the output of switch SWᵢ₋₁). The AFE portion of circuit 92ᵢ may include a Zener diode Z1 coupled between node 110 and node 114 (in particular, with the anode coupled to node 114 and the cathode coupled to node 110). The AFE portion of circuit 92ᵢ may include a current source G3 coupled between node 112 and ground GND, the current source G3 being configured to sink a current I from node 112. Furthermore, the selector portion of circuit 92ᵢ may include a passgate circuit block 116, including one or more CMOS passgate circuits. The passgate circuit block 116 may be configured for coupling at input at nodes 102ᵢ and 102ᵢ₋₁ to receive the voltages from the battery pins Cᵢ and Cᵢ₋₁, and may have two output nodes configured for providing the output signals to the selector circuits 94ᵢ and 94ᵢ₋₁ according to the scheme of Figure 9. Thus, for example, the passgate circuit block 116 may include four CMOS passgate circuits selectively activatable to implement all the possible input-to-output connection configurations. The passgate circuit block 116 may be biased between a secondary supply node 118 that produces a secondary supply voltage *V_{dd}',* and the node 112 that produces a floating ground voltage *GND_FLOAT.* An n-channel MOS transistor MN3 may be coupled between the power supply rail 106 and the secondary supply node 118, in particular with the source terminal coupled to node 118, the drain terminal coupled to rail 106, and the gate terminal coupled to the biasing node 110. A Zener diode Z2 may be coupled between node 118 and node 112, in particular with the anode coupled to node 112 and the cathode coupled to node 118.

Figure 10 shows the detailed structure of switch SWᵢ, switch SWᵢ₋₁ and AFE and selector circuit 92ᵢ, while the detailed structure of switch SWᵢ₋₂ and AFE and selector circuit 92ᵢ₋₁ are not visible for the sake of ease of illustration. However, it will be understood that, in order to implement the full architecture of MUX 72 (for a pair of battery cells) as exemplified in Figure 9, a third switch SWᵢ₋₂ having the same detailed architecture of switches SWᵢ and SWᵢ₋₁ can be implemented (arranged between a respective input node 100ᵢ₋₂ coupled to pin Cᵢ₋₂ and a respective output node 102ᵢ₋₂) and a second AFE and selector circuit 92ᵢ₋₁ having the same detailed architecture of AFE and selector circuit 92ᵢ can be implemented (having its first and second input terminal respectively coupled to nodes 102ᵢ₋₁ and 102ᵢ₋₂).

Operation of the switches SWᵢ, switch SWᵢ₋₁ and AFE and selector circuit 92ᵢ as exemplified in Figure 10 will now be discussed in detail. Substantially, the current source G1ᵢ can be selectively enabled or disabled (e.g., activated or de-activated) to make selectively conductive or non-conductive the switch SWᵢ, and the same applies to the current source G1ᵢ₋₁ for the switch SWᵢ₋₁. Looking at the operation of switch SWᵢ when it is activated, normally the voltage *N_{sw_gate}* at node 108ᵢ (i.e., at the gate terminals of transistors MN1ᵢ and MN2ᵢ) is biased at *R*Iᵢ+V_{GS}(MP1ᵢ)* above the voltage of the source terminal of transistor MN1ᵢ (where R is the resistance of resistor Rᵢ, *Iᵢ* is the current provided by generator G1ᵢ, and *V_{GS}(MP1ᵢ)* is the gate-source voltage of transistor MP1ᵢ). When transistor MN1ᵢ is ON, the source terminal of transistor MN1ᵢ and the voltage at node 102ᵢ (node C_{i_int}) are equal to the voltage of node 100ᵢ (pin Cᵢ). If the voltage at pin Cᵢ is higher than the voltage at pin Cᵢ₋₁, the voltage *N_{sw_gate}* at node 108ᵢ will be equal to the sum of voltage of pin Cᵢ, plus the voltage across resistor Rᵢ (that is, the product *R*Iᵢ),* plus the gate-source voltage *V_{GS}(MP1ᵢ)* of transistor MP1ᵢ, until the voltage *N_{sw_gate}* reaches the value *V_{clamp}*+*V_{be}*, where *V_{clamp}* is the voltage at the biasing node 110 and *V_{be}* is the threshold voltage of diode Dᵢ. Since voltage *V_{clamp}* is equal to the sum of voltage of pin Cᵢ₋₁, plus the gate-source voltage *V_{GS}(MP3)* of transistor MP3, plus the Zener voltage *V_{z}* of the Zener diode Z1, then the voltage *N_{sw_gate}* is clamped to a value equal to Cᵢ₋₁*+V_{GS}(MP3)+V_{z}+V_{be},* and the voltage at node 102ᵢ is clamped to a value equal to Cᵢ₋₁*+V_{GS}(MP3) +V_{z}-Vₜₕ(MN1ᵢ)+V_{be}* that is safe for the CMOS component inside the passgate block 116 (*Vₜₕ(MN1ᵢ)* being the threshold voltage of transistor MN1ᵢ). Also, it will be noted that node 114 is biased at a voltage *Vₛₚ* that is equal to the lowest between the voltage at pin Cᵢ and the voltage at pin Cᵢ₋₁, plus *V_{GS}(MP2)* if Cᵢ<Cᵢ₋₁ or *V_{GS}(MP3)* if Cᵢ>Cᵢ₋₁. The voltage *V_{clamp}* is equal to *Vₛₚ* plus the Zener voltage *V_{z}* of the Zener diode Z1.

It will be noted that, thanks to the AFE function described herein, the switches of the selector circuits 92ᵢ and 92ᵢ₋₁ have to withstand just the absolute differential rating of a single battery cell (e.g., 5.5 V), so they can be advantageously implemented as low-voltage switches (e.g., by CMOS5V technology).

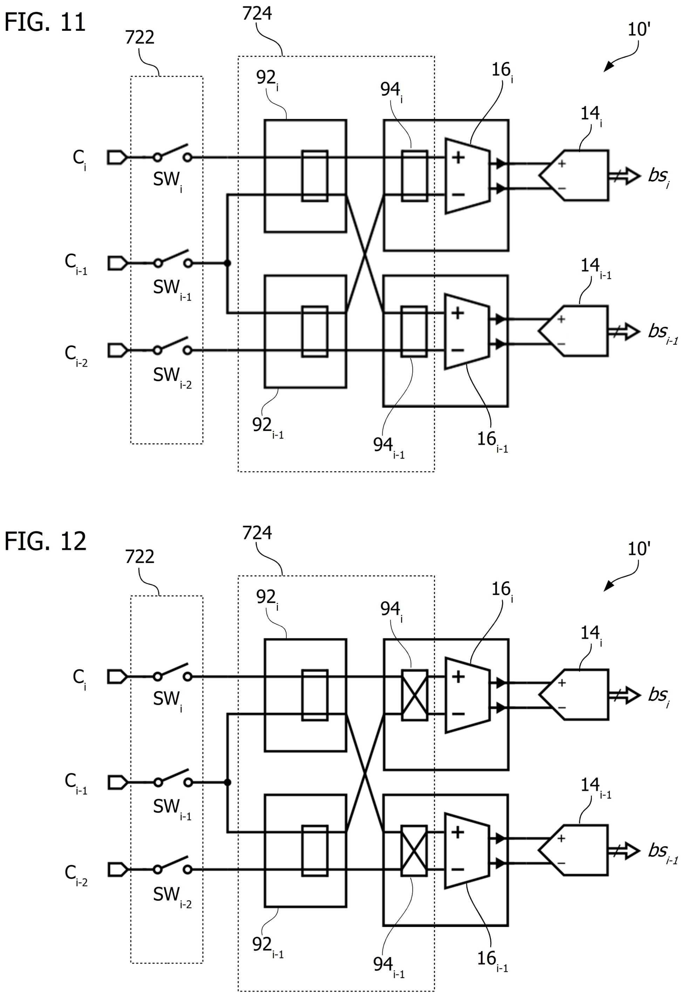

Figure 11 is a circuit block diagram exemplary of the possible arrangement of the selectors 92 and 94 of the MUX 72 (still with reference to a single pair of battery cells and corresponding ADCs, which can be replicated for each pair in the battery stack B) when there is no swapping (swap = '0') nor chopping (chop = '0'). In selector 92ᵢ the first input is coupled to the first output and the second input is coupled to the second output, in selector 92ᵢ₋₁ the first input is coupled to the first output and the second input is coupled to the second output, in selector 94ᵢ the first input is coupled to the first output and the second input is coupled to the second output, and in selector 94ᵢ₋₁ the first input is coupled to the first output and the second input is coupled to the second output. By doing so, the positive input of the even-numbered ADC 14ᵢ is coupled (via the level shifter 16ᵢ) to the cathode of the corresponding even-numbered cell Cellᵢ at pin Cᵢ, the negative input of the even-numbered ADC 14ᵢ is coupled (via the level shifter 16ᵢ) to the anode of the corresponding even-numbered cell Cellᵢ at pin Cᵢ₋₁, the positive input of the odd-numbered ADC 14ᵢ₋₁ is coupled (via the level shifter 16ᵢ₋₁) to the cathode of the corresponding odd-numbered cell Cellᵢ₋₁ at pin Cᵢ₋₁, and the negative input of the odd-numbered ADC 14ᵢ₋₁ is coupled (via the level shifter 16ᵢ₋₁) to the anode of the corresponding odd-numbered cell Cellᵢ₋₁ at pin Cᵢ₋₂.

Figure 12 is a circuit block diagram exemplary of the possible arrangement of the selectors 92 and 94 of the MUX 72 (still with reference to a single pair of battery cells and corresponding ADCs) when there is no swapping (swap = '0') but there is chopping (chop = '1'). In selector 92ᵢ the first input is coupled to the first output and the second input is coupled to the second output, in selector 92ᵢ₋₁ the first input is coupled to the first output and the second input is coupled to the second output, in selector 94ᵢ the first input is coupled to the second output and the second input is coupled to the first output, and in selector 94ᵢ₋₁ the first input is coupled to the second output and the second input is coupled to the first output. By doing so, the positive input of the even-numbered ADC 14ᵢ is coupled (via the level shifter 16ᵢ) to the anode of the corresponding even-numbered cell Cellᵢ at pin Cᵢ₋₁, the negative input of the even-numbered ADC 14ᵢ is coupled (via the level shifter 16ᵢ) to the cathode of the corresponding even-numbered cell Cellᵢ at pin Cᵢ, the positive input of the odd-numbered ADC 14ᵢ₋₁ is coupled (via the level shifter 16ᵢ₋₁) to the anode of the corresponding odd-numbered cell Cellᵢ₋₁ at pin Cᵢ₋₂, and the negative input of the odd-numbered ADC 14ᵢ₋₁ is coupled (via the level shifter 16ᵢ₋₁) to the cathode of the corresponding odd-numbered cell Cellᵢ₋₁ at pin Cᵢ₋₁.

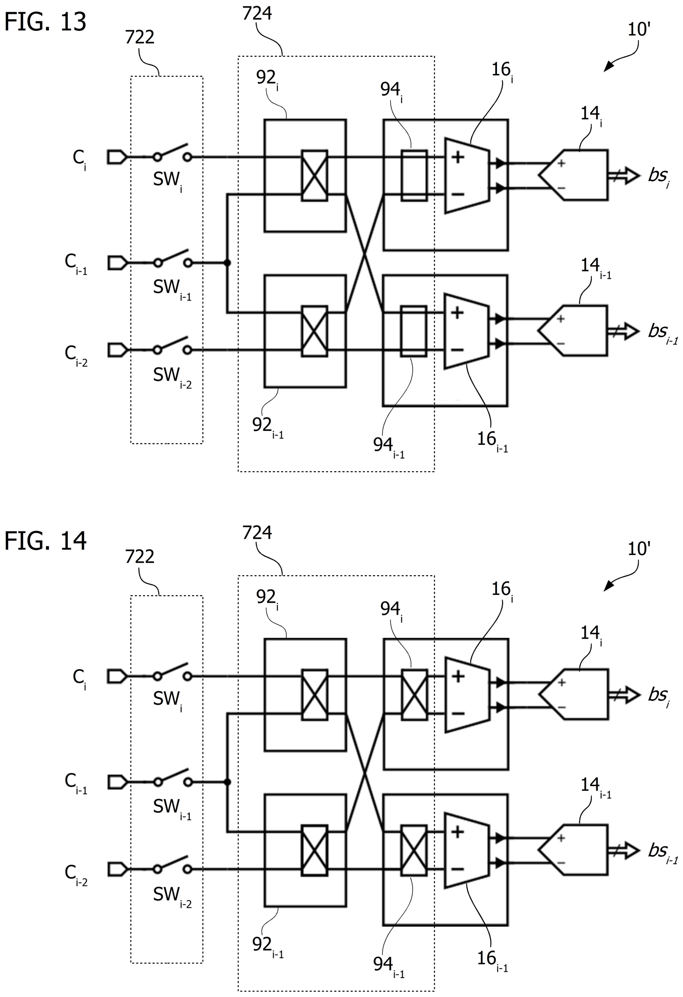

Figure 13 is a circuit block diagram exemplary of the possible arrangement of the selectors 92 and 94 of the MUX 72 (still with reference to a single pair of battery cells and corresponding ADCs) when there is swapping (swap = '1') and no chopping (chop = '0'). In selector 92ᵢ the first input is coupled to the second output and the second input is coupled to the first output, in selector 92ᵢ₋₁ the first input is coupled to the second output and the second input is coupled to the first output, in selector 94ᵢ the first input is coupled to the first output and the second input is coupled to the second output, and in selector 94ᵢ₋₁ the first input is coupled to the first output and the second input is coupled to the second output. By doing so, the positive input of the even-numbered ADC 14ᵢ is coupled (via the level shifter 16ᵢ) to the cathode of the corresponding odd-numbered cell Cellᵢ₋₁ at pin Cᵢ₋₁, the negative input of the even-numbered ADC 14ᵢ is coupled (via the level shifter 16ᵢ) to the anode of the corresponding odd-numbered cell Cellᵢ₋₁ at pin Cᵢ₋₂, the positive input of the odd-numbered ADC 14ᵢ₋₁ is coupled (via the level shifter 16ᵢ₋₁) to the cathode of the corresponding even-numbered cell Cellᵢ at pin Cᵢ, and the negative input of the odd-numbered ADC 14ᵢ₋₁ is coupled (via the level shifter 16ᵢ₋₁) to the anode of the corresponding even-numbered cell Cellᵢ at pin Cᵢ₋₁.

Figure 14 is a circuit block diagram exemplary of the possible arrangement of the selectors 92 and 94 of the MUX 72 (still with reference to a single pair of battery cells and corresponding ADCs) when there is both swapping (swap = '1') and chopping (chop = '1'). In selector 92ᵢ the first input is coupled to the second output and the second input is coupled to the first output, in selector 92ᵢ₋₁ the first input is coupled to the second output and the second input is coupled to the first output, in selector 94ᵢ the first input is coupled to the second output and the second input is coupled to the first output, and in selector 94ᵢ₋₁ the first input is coupled to the second output and the second input is coupled to the first output. By doing so, the positive input of the even-numbered ADC 14ᵢ is coupled (via the level shifter 16ᵢ) to the anode of the corresponding odd-numbered cell Cellᵢ₋₁ at pin Cᵢ₋₂, the negative input of the even-numbered ADC 14ᵢ is coupled (via the level shifter 16ᵢ) to the cathode of the corresponding odd-numbered cell Cellᵢ₋₁ at pin Cᵢ₋₁, the positive input of the odd-numbered ADC 14ᵢ₋₁ is coupled (via the level shifter 16ᵢ₋₁) to the anode of the corresponding even-numbered cell Cellᵢ at pin Cᵢ₋₁, and the negative input of the odd-numbered ADC 14ᵢ₋₁ is coupled (via the level shifter 16ᵢ₋₁) to the cathode of the corresponding even-numbered cell Cellᵢ at pin Cᵢ.

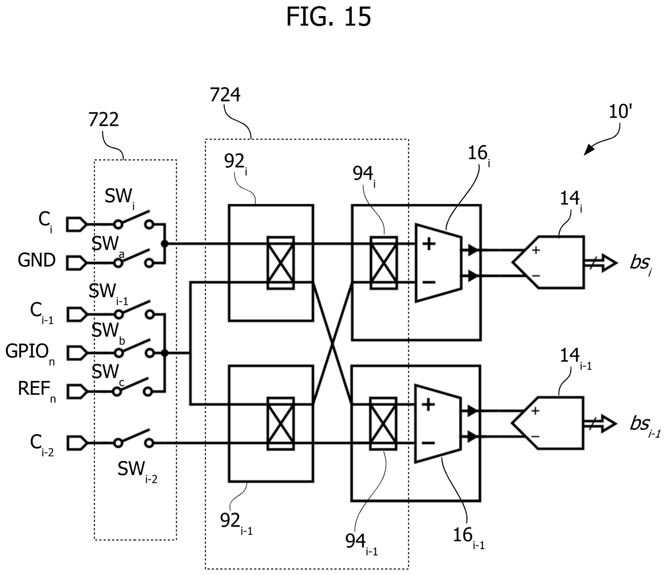

Turning back to the more general architecture exemplified in Figure 7 and in Figure 9, and making now reference to the circuit block diagram of Figure 15, it is noted that in some applications some (or even all) of the ADCs 14 (e.g., from 14ᵢ to 14ₙ) may be used to read a voltage from a general-purpose input pin (GPIO) GPIOₙ which is referred to ground GND, so two more switches may be implemented in one or more embodiments, in particular an additional switch SWₐ that allows to selectively connect the ground terminal GND to the first input terminal of the AFE and selector circuit 92ᵢ, and an additional switch SW_{b} that allows to selectively connect the GPIO pin GPIOₙ to the second input terminal of the AFE and selector circuit 92ᵢ (and to the first input terminal of the AFE and selector circuit 92ᵢ₋₁). Furthermore, in some applications, in order to perform a built-in self-test (BIST) of the MUX 72, some (or even all) of the ADCs 14 (e.g., from 14ᵢ to 14ₙ) may be used to receive a reference voltage from a reference pin REFₙ, so one more switch may be implemented in one or more embodiments, in particular an additional switch SW_{c} that allows to selectively connect the reference pin REFₙ to the second input terminal of the AFE and selector circuit 92ᵢ (and to the first input terminal of the AFE and selector circuit 92ᵢ₋₁).

Compared to the architecture of Figure 2, one or more embodiments may thus provide the possibility of implementing just one high-voltage switch, instead of four high-voltage switches, for each pin of the battery stack. The lower number of high-voltage switches results in a smaller silicon footprint (lower silicon area occupation). Furthermore, the swap and chop switches can be realized in low-voltage technology (e.g., CMOS5V) and can be optimized to work together, avoiding the addition of another pair of high-voltage switches.

Without prejudice to the underlying principles, the details and embodiments may vary, even significantly, with respect to what has been described by way of example only, without departing from the extent of protection.

The extent of protection is determined by the annexed claims.

## Claims

1. A multiplexer circuit, MUX (72) for a battery management system (10'), the MUX (72) comprising:
a first input terminal configured for coupling to a first pin (Cᵢ) of a battery stack (B), a second input terminal configured for coupling to a second pin (Cᵢ₋₁) of the battery stack (B), and a third input terminal configured for coupling to a third pin (Cᵢ₋₂) of the battery stack (B);
a first switch (SWᵢ) having a respective first terminal (100ᵢ) coupled to the first input terminal of the MUX, a second switch (SWᵢ₋₁) having a respective first terminal (100ᵢ₋₁) coupled to the second input terminal of the MUX, and a third switch (SWᵢ₋₂) having a respective first terminal (100ᵢ₋₂) coupled to the third input terminal of the MUX;
an analog front end, AFE, and selection circuit (724) comprising:
a first input terminal coupled to a second terminal (102ᵢ) of said first switch (SWᵢ),
a second input terminal coupled to a second terminal (102ᵢ₋₁) of said second switch (SWᵢ₋₁),
a third input terminal coupled to a second terminal (102ᵢ₋₂) of said third switch (SWᵢ₋₂),
a first output terminal configured for coupling to a positive input of a first level shifter circuit (16ᵢ),
a second output terminal configured for coupling to a negative input of the first level shifter circuit (16ᵢ),
a third output terminal configured for coupling to a positive input of a second level shifter circuit (16ᵢ₋₁), and
a fourth output terminal configured for coupling to a negative input of the second level shifter circuit (16ᵢ₋₁);
wherein each of said first, second, third and fourth output terminals of the AFE and selection circuit (724) is selectively couplable to any of said first, second and third input terminals of the AFE and selection circuit (724).

2. The multiplexer circuit (72) of claim 1, wherein said AFE and selection circuit (724) comprises:
a first 4:1 MUX (82ᵢ) having three inputs respectively coupled to the first, second and third input terminal of the AFE and selection circuit (724) and having one output coupled to the first output terminal of the AFE and selection circuit (724);
a second 4:1 MUX (84ᵢ) having three inputs respectively coupled to the first, second and third input terminal of the AFE and selection circuit (724) and having one output coupled to the second output terminal of the AFE and selection circuit (724);
a third 4:1 MUX (82ᵢ₋₁) having three inputs respectively coupled to the first, second and third input terminal of the AFE and selection circuit (724) and having one output coupled to the third output terminal of the AFE and selection circuit (724); and
a fourth 4:1 MUX (84ᵢ₋₁) having three inputs respectively coupled to the first, second and third input terminal of the AFE and selection circuit (724) and having one output coupled to the fourth output terminal of the AFE and selection circuit (724).

3. The multiplexer circuit (72) of claim 1, wherein said AFE and selection circuit (724) comprises a first selector (92ᵢ), a second selector (92ᵢ₋₁), a third selector (94ᵢ) and a fourth selector (94ᵢ₋₁), wherein each of said selectors (92ᵢ, 92ᵢ₋₁, 94ᵢ, 94ᵢ₋₁) has respective first and second inputs and respective first and second outputs, wherein any output of each selector is selectively couplable to any input of the same selector, and wherein:
the first input of the first selector (92ᵢ) is connected to the first input terminal of the AFE and selection circuit (724);
the second input of the first selector (92ᵢ) is connected to the second input terminal of the AFE and selection circuit (724);
the first input of the second selector (92ᵢ₋₁) is connected to the second input terminal of the AFE and selection circuit (724);
the second input of the second selector (92ᵢ₋₁) is connected to the third input terminal of the AFE and selection circuit (724);
the first input of the third selector (94ᵢ) is connected to the first output of the first selector (92ᵢ);
the second input of the third selector (94ᵢ) is connected to the first output of the second selector (92ᵢ₋₁) ;
the first input of the fourth selector (94ᵢ₋₁) is connected to the second output of the first selector (92ᵢ);
the second input of the fourth selector (94ᵢ₋₁) is connected to the second output of the second selector (92ᵢ₋₁) ;
the first output of the third selector (94ᵢ) is connected to the positive input of the first level shifter circuit (16ᵢ);
the second output of the third selector (94ᵢ) is connected to the negative input of the first level shifter circuit (16ᵢ);
the first output of the fourth selector (94ᵢ₋₁) is connected to the positive input of the second level shifter circuit (16ᵢ₋₁); and
the second output of the fourth selector (94ᵢ₋₁) is connected to the negative input of the second level shifter circuit (16ᵢ₋₁).

4. The multiplexer circuit (72) of any of the previous claims, wherein each of said first (SWᵢ), second (SWᵢ₋₁) and third (SWᵢ₋₂) switches comprises a first transistor (MN1) and a second transistor (MN2) having respective conductive channels arranged in series between the input terminal (100) and the output terminal (102) of the switch (SW).

5. The multiplexer circuit (72) of claim 4, wherein in each of said first (SWᵢ), second (SWᵢ₋₁) and third (SWᵢ₋₂) switches, the first transistor (MN1) includes an n-channel MOS transistor having a drain terminal coupled to the input terminal (100) of the switch (SW), a source terminal coupled to a common node (104), and a gate terminal coupled to a selection node (108), and the second transistor (MN2) includes an n-channel MOS transistor having a drain terminal coupled to the output terminal (102) of the switch (SW), a source terminal coupled to said common node (104), and a gate terminal coupled to the selection node (108).

6. The multiplexer circuit (72) of claim 5, wherein each of said first (SWᵢ), second (SWᵢ₋₁) and third (SWᵢ₋₂) switches comprises:
a current source (G1) coupled between a power supply rail (106) and the selection node (108), and configured to source a current to the selection node (108); and
a resistor (R) and a third transistor (MP1) arranged in series between the selection node (108) and ground (GND) .

7. The multiplexer circuit (72) of claim 6, wherein in each of said first (SWᵢ), second (SWᵢ₋₁) and third (SWᵢ₋₂) switches, the third transistor (MP1) comprises a p-channel MOS transistor having a drain terminal coupled to ground (GND), a source terminal coupled to the respective resistor (R), and a gate terminal coupled to the common node (104).

8. The multiplexer circuit (72) of any of claims 5 to 7, wherein each of said first (SWᵢ), second (SWᵢ₋₁) and third (SWᵢ₋₂) switches comprises a diode (D) having an anode terminal coupled to the selection node (108) and a cathode terminal coupled to a biasing node (110).

9. The multiplexer circuit (72) of claim 3 possibly in combination with any of claims 4 to 8, wherein each of said first (92ᵢ) and second (92ᵢ₋₁) selectors comprises:
a current source (G2) coupled between a power supply rail (106) and a biasing node (110), and configured to source a current to the biasing node (110);
a Zener diode (Z1) having an anode terminal coupled to a further biasing node (114) and a cathode terminal coupled to the biasing node (110);
a fourth transistor (MP2) and a fifth transistor (MP3) having respective conductive channels arranged in parallel between the further biasing node (114) and a floating ground node (112), wherein the control terminal of the fourth transistor (MP2) is connected to the first input node of the selector (92) and the control terminal of the fifth transistor (MP3) is connected to the second input node of the selector (92); and
a further current source (G3) coupled between the floating ground node (112) and ground (GND), and configured to sink a current from the floating ground node (112).

10. The multiplexer circuit (72) of claim 3 possibly in combination with any of claims 4 to 9, wherein each of said first (92ᵢ) and second (92ᵢ₋₁) selectors comprises a passgate circuit block (116) coupled between the two inputs of the selector (92) and the two outputs of the selector (92), and comprising one or more CMOS passgate circuits to selectively couple any output of the selector (92) to any input of the selector (92).

11. The multiplexer circuit (72) of claim 10, wherein each of said first (92ᵢ) and second (92ᵢ₋₁) selectors comprises:
a sixth transistor (MN3) having a conductive channel arranged between said power supply rail (106) and a secondary supply node (118) and a control terminal coupled to said biasing node (110); and
a second Zener diode (Z2) having an anode terminal coupled to said floating ground node (112) and a cathode terminal coupled to said secondary supply node (118);
wherein the passgate circuit block (116) is biased between the secondary supply node (118) and the floating ground node (112).

12. The multiplexer circuit (72) of any of the previous claims, comprising:
a fourth input terminal configured for coupling to ground (GND), and a fifth input terminal configured for coupling to a general-purpose input pin (GPIOₙ); and
a fourth switch (SWₐ) having a respective first terminal coupled to the fourth input terminal of the MUX, and a fifth switch (SW_{b}) having a respective first terminal coupled to the fifth input terminal of the MUX;
wherein the first input terminal of the AFE and selection circuit (724) is coupled to a second terminal of said fourth switch (SWₐ) and the second input terminal of the AFE and selection circuit (724) is coupled to a second terminal of said fifth switch (SW_{b}).

13. The multiplexer circuit (72) of any of the previous claims, comprising:
a sixth input terminal configured for coupling to a reference pin (REFₙ); and
a sixth switch (SW_{c}) having a respective first terminal coupled to the sixth input terminal of the MUX;
wherein the second input terminal of the AFE and selection circuit (724) is coupled to a second terminal of said sixth switch (SW_{c}).

14. A battery management system (10') comprising:
a multiplexer circuit (72) according to any of the previous claims;
a first level shifter circuit (16i) having a positive input coupled to the first output terminal of said AFE and selection circuit (724), a negative input coupled to the second output terminal of said AFE and selection circuit (724), and an output port;
a second level shifter circuit (16ᵢ₋₁) having a positive input coupled to the third output terminal of said AFE and selection circuit (724), a negative input coupled to the fourth output terminal of said AFE and selection circuit (724), and an output port;
a first ADC circuit (14ᵢ) having an input port coupled to the output port of the first level shifter circuit (16ᵢ); and
a second ADC circuit (14ᵢ₋₁) having an input port coupled to the output port of the second level shifter circuit (16ᵢ₋₁).

15. The battery management system (10') of claim 14, wherein the third pin (Cᵢ₋₂) of the battery stack (B) is connected to an anode terminal of an odd-numbered cell (Cell₁) of the battery stack (B), the second pin (Cᵢ₋₁) of the battery stack (B) is connected to a cathode terminal of said odd-numbered cell (Cell₁) of the battery stack (B) and to an anode terminal of a subsequent even-numbered cell (Cell₂) of the battery stack (B), and the first pin (Cᵢ) of the battery stack (B) is connected to a cathode terminal of said subsequent even-numbered cell (Cell₂) of the battery stack (B).
